# EUROPEAN PATENT SPECIFICATION

(11) **EP 0 451 641 B1**
(45) Date of publication and mention of the grant of the patent: **07.06.1995**
(21) Application number: 91105025.0
(22) Date of filing: 28.03.1991
(51) Int. Cl.: H01L 39/24

(54) **Method of manufacturing oxide high-temperature superconductor thin film by means of molecular-beam epitaxy**
Methode zur Herstellung von oxydischen Hochtemperatursupraleitern mit Hilfe der Molekularstrahlepitaxie
Procédé pour la fabrication d'un film mince d'un oxyde supraconducteur à haute température par épitaxie à faisceau moléculaire

(30) Priority: 13.04.1990 JP 98484/90
(43) Date of publication of application: 16.10.1991
(73) Proprietor: President of TOKYO INSTITUTE OF TECHNOLOGY, Tokyo (JP)
(72) Inventor: Kawai, Maki, Tokyo (JP); Watanabe, Shunji, Tokyo (JP)
(74) Representative: Hansen, Bernd, Dr. Dipl.-Chem.

(56) References cited:
- EP-A- 0 308 266
- GB-A- 2 211 209
- JAPANESE JOURNAL OF APPLIED PHYSICS vol. 28, no. 7, part 2, July 1989, pages L1217-L1219, Tokyo, JP; Y. NAKAYAMA et al.: "In Situ Growth of Bi-Sr-Ca-Cu-O Thin Films by Molecular Beam Epitaxy Technique with Pure Ozone"
- PATENT ABSTRACTS OF JAPAN vol. 13, no. 254 (E-772)(3602), 13 June 1989; & JP - A - 151682 (SUMITOMO ELECTRIC) 27.02.1989

## Description

The present invention relates to a method of manufacturing an oxide high-temperature superconductor thin film by means of a molecular-beam epitaxy (to be referred to as an MBE hereinafter).

Conventionally, various film formation methods including a magnetron sputtering method, a laser sputtering method, a reactive vapor deposition method, and an MBE method have been attempted in the manufacture of an oxide high-temperature superconductor thin film.

In any of these methods, a structure of an oxide superconductor can be formed by precisely controlling film formation conditions.

In addition, various types of oxidation gases are used to incorporate oxygen into crystals, and it is known that a temperature required for formation of an oxide film changes in accordance with the type of gas used.

For example, in crystallization of a Bi-Sr-Cu-O superconductor, the crystallization conditions are as follows:
Oxidation temperature: 500°C or more
Required vacuum degree corresponding to type of oxidizing agent
- oxygen gas (O₂): :1.33 to 1.33 × 10⁻¹ Pa (10⁻² to 10⁻³ Torr)
- ozone (O₃): :1.33 × 10⁻³ Pa (10⁻⁵ Torr)

As described above, even when ozone which is conventionally considered to be most active is used, the crystallization temperature must be 500°C or more, and generally, 600°C to 700°C.

In addition, even when a highly active gas such as ozone is used, a required vacuum degree is at most about 1.33 × 10⁻³ Pa (10⁻⁵ Torr), i.e., outside a high vacuum range.

However, when an application of an oxide superconductor is taken into consideration, in particular, to form a composite structure with various types of other materials as electronics devices, a temperature of 500°C is too high and therefore impractical in terms of the heat resistances of the electronics devices.

Furthermore, to obtain a high-quality thin film by the film formation methods as described above, it is desired to execute film formation at a pressure as low as possible, i.e., within a high vacuum range. However, even when ozone having the highest activity is used, a gas pressure upon film formation must be 1.33 × 10⁻² to 1.33 × 10⁻³ Pa (10⁻⁴ to 10⁻⁵ Torr) or more. This pressure value is far from an ideal low pressure value for obtaining a high-quality thin film.

GB-A-2 211 209 reveals a method of forming a defect mixed oxide, wherein sources of gaseous material comprising the elements for forming the defect mixed oxide are directed at a substrate, and wherein the sources are switched on and off in a predetermined sequence so as to build up layer by layer on the substrate a unit cell of the defect mixed oxide.

According to the above MBE method, a single metal monoatomic layer is deposited on the substrate, wherein the oxidation with the help of oxygen or nitrous oxide is performed during or after the formation of a monoatomic layer on the substrate. This process is repeatedly executed a predetermined number of times to form an oxide high-temperature superconductor thin film having a predetermined thickness.

EP-A-308 266 discloses the use of nitrogen dioxide as an oxidizing gas in a process for forming an oxide superconducting thin film.

The present invention has been made in consideration of the above situation and has as its object to provide a method of manufacturing an oxide superconductor thin film by means of an MBE, which can form an oxide superconductor thin film by executing oxidation at an ideal low pressure (within a high vacuum range) and at a low temperature which does not interfere with formation of a composite structure with various types of other materials as electronics devices or the like.

According to the present invention, there is provided a method of manufacturing an oxide superconductor thin film by means of a molecular-beam epitaxy, comprising the steps of:
sequentially forming monoatomic layers each formed of a single metal on a substrate using the molecular-beam epitaxy method to form a multilayered metal film consisting of all the types of metals in their stoichometric ratios required for the superconductor thin film to be formed;
after formation of the multilayered metal film, supplying nitrogen dioxide gas as an oxidizer to oxidize said multilayered metal film; and
repeatedly executing the same operation a predetermined number of times to form an oxide high-temperature superconductor thin film having a predetermined thickness.

This invention can be more fully understood from the following detailed description when taken in conjunction with the accompanying drawings, in which:
Fig. 1 is a sectional view showing a substrate and a thin film portion for explaining an embodiment of a method according to the present invention;
Fig. 2 is a timing chart showing an MBE method;
Fig. 3A is a side view showing an atomic layer-controlling oxide thin film formation apparatus;
Fig. 3B is a plan view thereof;
Figs. 4A to 4D are views showing measurement results obtained by reflection high energy electron diffraction;
Figs. 5 and 6 are graphs showing measurement results obtained by X-ray photoelectron spectroscopy; and
Fig. 7 is a graph showing an X-ray diffraction pattern of a formed oxide superconductor thin film.

The present invention will be described in detail below.

According to the present invention, monoatomic layers each formed of a single metal are sequentially formed on a substrate using an MBE method to form a multilayered metal film of a plurality of types of metals, and this multilayered metal film is oxidized by supplying nitrogen dioxide gas as an oxidizer. This operation is repeatedly executed a predetermined number of times to form an oxide superconductor thin film having a predetermined thickness.

In this method, in the process of supplying the nitrogen dioxide gas as an oxidizer to oxidize the multilayered metal film, the substrate temperature is preferably held at 300°C to 380°C.

In addition, in this oxidation process, a vacuum is preferably held at about 1.33 × 10⁻⁵ Pa (10⁻⁷ Torr).

According to the present invention, after the multilayered structure constituted by the single-metal films is formed on the substrate, oxidation is performed by nitrogen dioxide. Therefore, since the oxide superconductor thin films can be grown one after another, film formation can be performed at a low temperature in a high vacuum compared to conventional methods. As a result, a high-quality film can be obtained. In addition, since the film formation temperature can be decreased, a composite structure with other electronics devices can be easily formed.

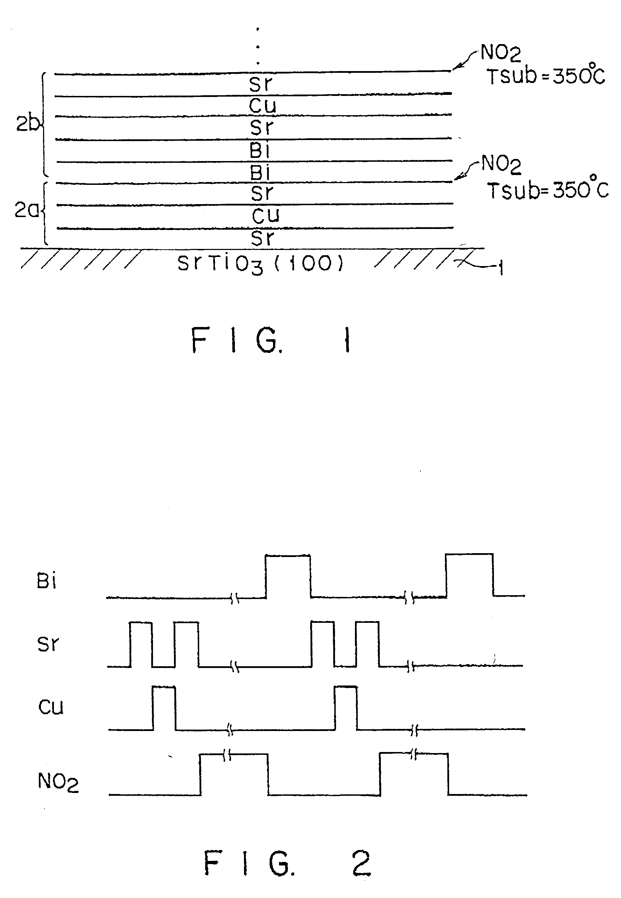

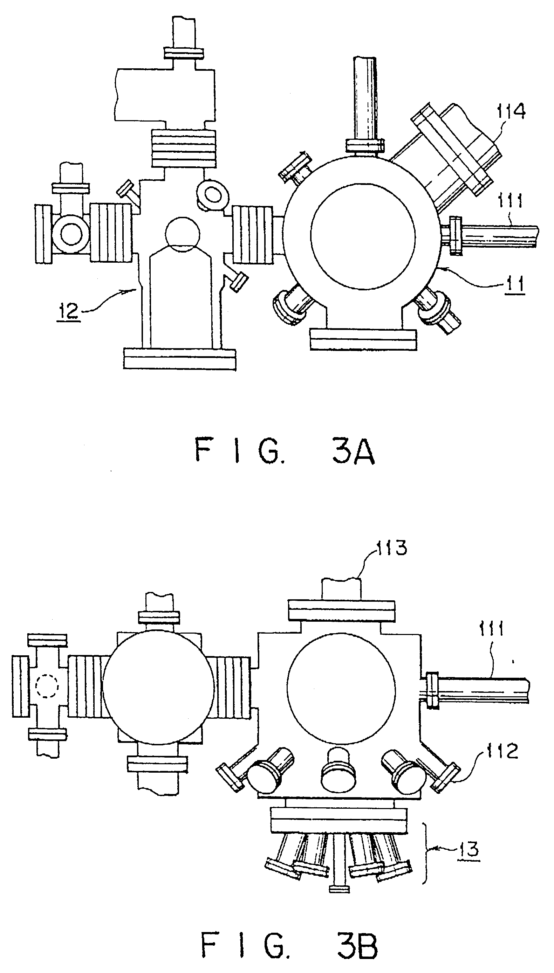

An embodiment of the method according to the present invention will be described below. Fig. 1 is a sectional view showing a thin film portion including a substrate according to this embodiment, and Fig. 2 is a timing chart of the MBE method.

In this embodiment, SrTiO₃ (100) is used as the material of a substrate 1. The substrate 1 is placed in an atomic layer-controlled oxide thin film formation apparatus (to be referred to as a thin film formation apparatus hereinafter) as shown in Figs. 3A and 3B, and a reaction chamber is evacuated to be 2.66 × 10⁻⁸ Pa (2 × 10⁻¹⁰ Torr).

As a first group of metal monoatomic layers 2a, films of Sr, Cu, and Sr are formed on the substrate 1 in the order named from the substrate 1 in a vacuum of 1.33 × 10⁻⁶ Pa (10⁻⁸ Torr) at room temperature by the MBE, as shown in Fig. 1.

After the film formation of the first group of metal monoatomic layers 2a is completed, NO₂ gas is supplied in an atmosphere at 1.33 × 10⁻⁵ Pa (10⁻⁷ Torr) and 300°C to oxidize the layers 2a.

While the oxidation process progresses, a degree of progress of the oxide film formation is measured by reflection high energy electron diffraction. Although both streaks and spots are found during progress of the NO₂ oxidation, only the streaks remain after further continuation of the oxidation to indicate that the oxidation and the crystallization are completed.

After the oxidation of the first group of metal monoatomic layers 2a is completed, a second group of metal monoatomic layers 2b constituted by Bi, Bi, Sr, Cu, and Sr films are formed following the same procedures as for the first layers 2a. The second metal monoatomic layers 2b are oxidized and the end of oxidation is checked following the same procedures as for the first group of metal monoatomic layers 2a.

In this manner, the operation is repeatedly performed until a thin film having a necessary thickness is formed.

A thin film formation apparatus as an apparatus for performing the above film formation is shown in Figs. 3A and 3B, in which Fig. 3A is a side view of the apparatus and Fig. 3B is a plan view thereof. This apparatus comprises as its main parts a reflection high energy electron diffraction device 11, an electron spectroscopy device 12, and a multielement vapor deposition device 13.

Of these devices, the reflection high energy electron diffraction device 11 includes a sample conveyor mechanism 111, a gas supply mechanism 112, a manipulator 113, and an exhaust system 114.

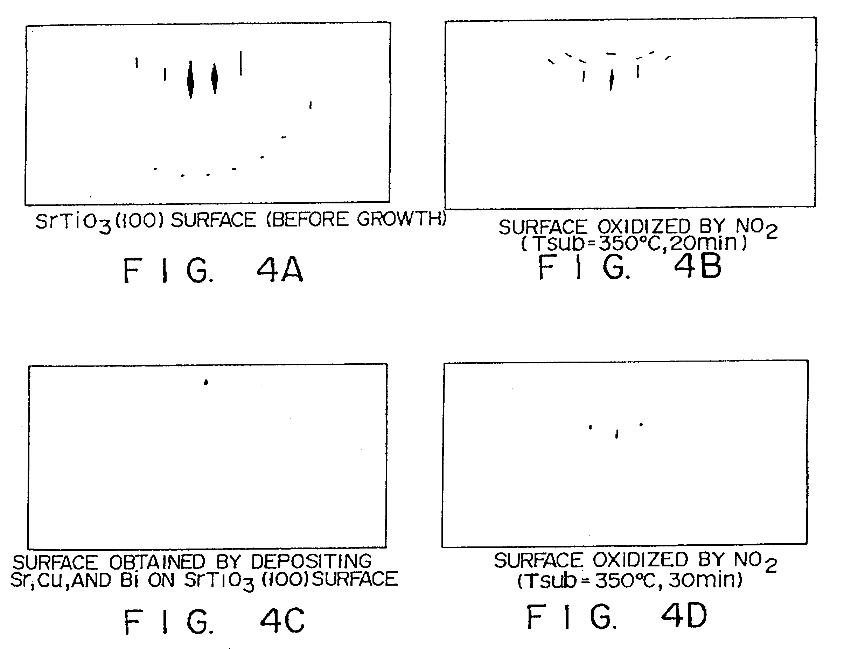

Figs. 4A to 4D show the measurement results of the progress degree of the oxide film formation obtained by the reflection high energy electron diffraction device described above. Fig. 4A shows a state of the surface of the substrate 1 obtained before the metal monoatomic layers are formed; Fig. 4B, a state obtained after the NO₂ oxidation is performed (at a temperature of 350°C and a pressure of 2.66 × 10⁻⁵ Pa (2 × 10⁻⁷ Torr) for 20 minutes), in which streaks and spots are found; Fig. 4C, a state obtained when the Sr, Cu, and Bi films are formed on the substrate 1; and Fig. 4D, a state obtained after the NO₂ oxidation is further executed (at a temperature of 350°C and a pressure of 2.66 × 10⁻⁵ Pa (2 × 10⁻⁷ Torr) for 30 minutes), in which only the streaks remain.

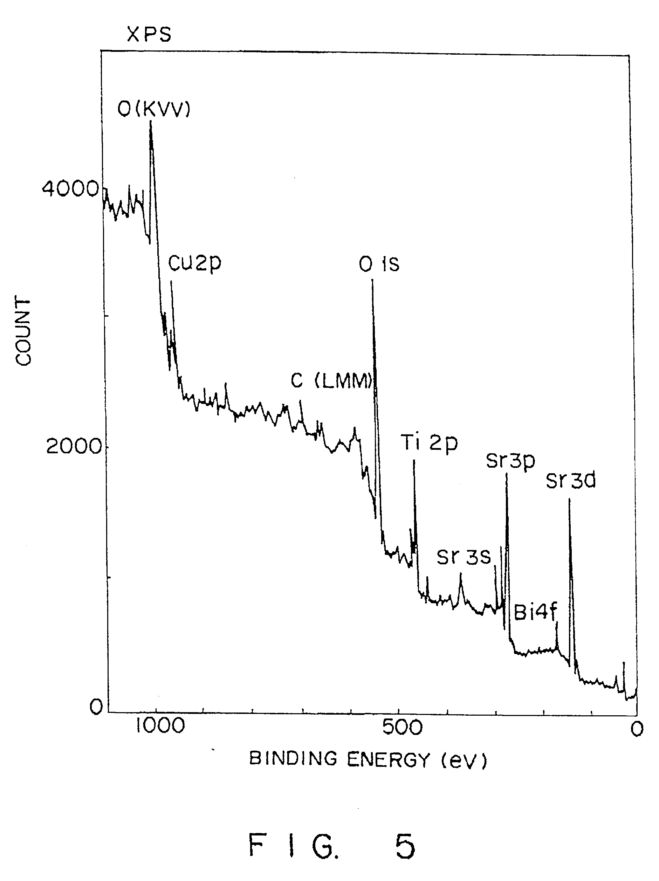

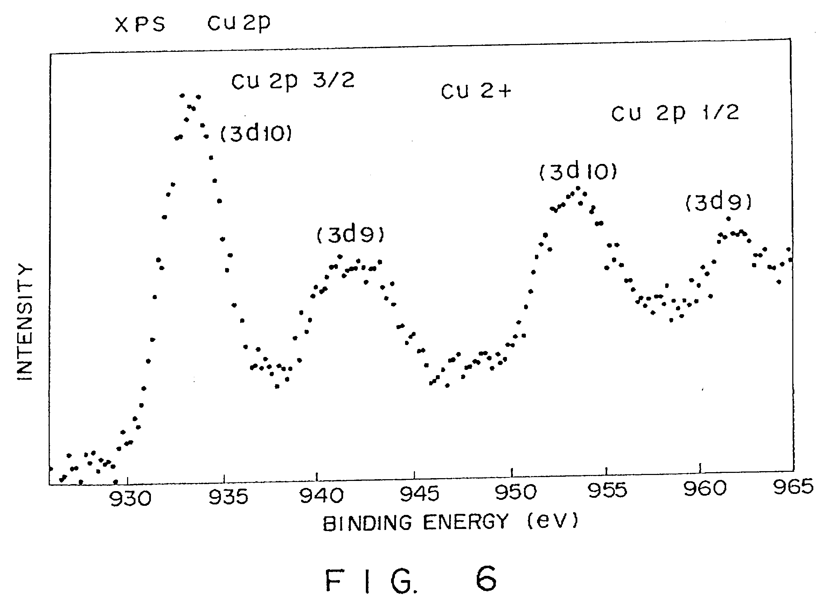

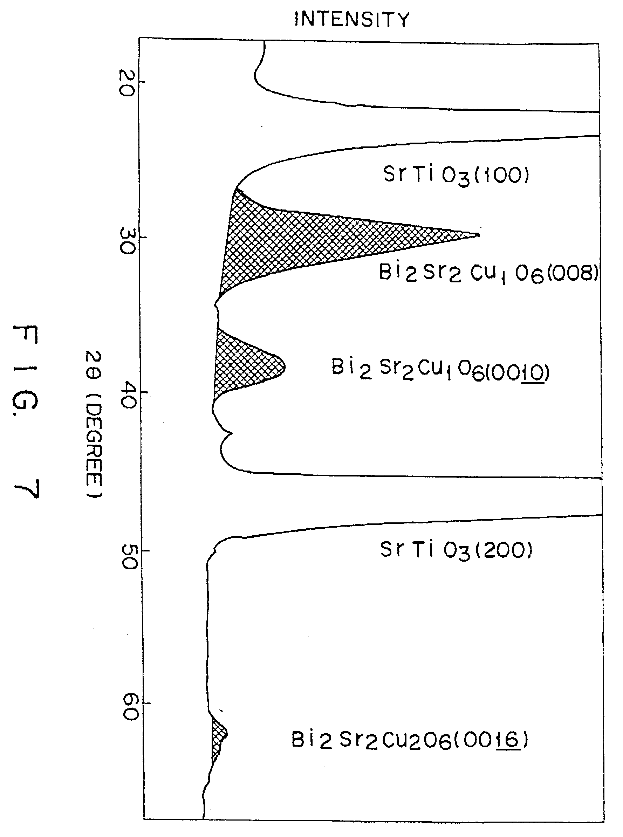

Fig. 5 shows measurement results obtained by the X-ray photoelectron spectroscopy (XPS), which indicates that necessary elements are present in the thin film. Fig. 6 shows measurement results similarly obtained by the XPS, which indicates that even copper, which is a most difficult one to be oxidized of these elements, is in a required oxidation state. Fig. 7 shows an X-ray diffraction pattern of the formed film, indicating that the film has a Bi₂Sr₂Cu₁O₆ structure.

According to this embodiment, since Bi₂Sr₂CuOₓ layers can be grown one after another on the SrTiO₃ (100) substrate 1 at 300°C and 2.66 × 10⁻⁵ Pa (2 × 10⁻⁷ Torr) using NO₂, film formation can be performed at a low temperature in a high vacuum compared to conventional methods. As a result, a high-quality film can be obtained. In addition, since the film formation temperature can be decreased, a composite structure with other electronics devices can be easily formed.

Note that although SrTiO₃ and Bi₂Sr₂CuO are used as the materials of the substrate and the oxide superconductor, respectively, in the above embodiment, the materials are not limited to these materials.

## Claims

1. A method of manufacturing an oxide superconductor thin film by means of a molecular-beam epitaxy, comprising the steps of:
sequentially forming monoatomic layers each formed of a single metal on a substrate using the molecular-beam epitaxy method to form a multilayered metal film consisting of all the types of metals in their stoichometric ratios required for the superconductor thin film to be formed;
after formation of the multilayered metal film, supplying nitrogen dioxide gas as an oxidizer to oxidize said multilayered metal film; and
repeatedly executing the same operation a predetermined number of times to form an oxide high-temperature superconductor thin film having a predetermined thickness.

2. A method according to claim 1, characterized in that in said oxidation step of supplying the nitrogen dioxide gas as an oxidizer to oxidize said multilayered metal film, the temperature is held at 300°C to 380°C.

3. A method according to claim 1, characterized in that in said oxidation step of supplying the nitrogen dioxide gas as an oxidizer to oxidize said multilayered metal film, the vacuum is held at about 1.33 × 10⁻⁵ Pa (10⁻⁷ Torr).

## Patentansprüche

1. Verfahren zur Herstellung eines dünnen Supraleiteroxidfilms mittels Molekularstrahlepitaxie, umfassend die Schritte:
der Reihe nach Ausbilden von Monoatomschichten, wobei jede aus einem Einzelmetall gebildet wird, auf einem Substrat unter Verwendung des Molekularstahl-Epitaxieverfahrens unter Bildung eines Vielschicht-Metallfilms, bestehend aus all den Metalltypen in ihren stöchiometrischen Verhältnissen, die für den zu bildenden dünnen Supraleiterfilm erforderlich sind;
nach Ausbildung des Vielschicht-Metallfilms, Zuführen von Stickstoffdioxidgas in einen Oxidator unter Oxidation des Multischicht-Metallfilms; und
wiederholtes Durchführen des gleichen Arbeitsganges für eine vorbestimmte Anzahl unter Bildung eines dünnen Hochtemperatur-Supraleiteroxidfilms mit einer bestimmten Dicke.

2. Verfahren nach Anspruch 1, dadurch **gekennzeichnet**, daß bei dem Oxidationsschritt der Zufuhr des Stickstoffdioxidgases als Oxidationsmittel zur Oxidation des Vielschicht-Metallfilmes die Temperatur auf 300°C bis 380°C gehalten wird.

3. Verfahren nach Anspruch 1, dadurch **gekennzeichnet**, daß bei dem Oxidationsschritt der Zufuhr des Stickstoffdioxidgases als Oxidationsmittel zur Oxidation des Multischicht-Metallfilmes das Vakuum auf ca. 1,33 × 10⁻⁵ Pa (10⁻⁷ Torr) gehalten wird.

## Revendications

1. Procédé de fabrication d'un film mince d'oxyde supraconducteur par épitaxie par jet moléculaire, comprenant les étapes consistant :
- à former sur un substrat séquentiellement des couches monoatomiques formée chacune d'un métal unique en utilisant le procédé d'épitaxie par jet moléculaire pour former un film métallique multi-couche constitué de tous les types de métaux en leur rapport stoechiométrique requis pour former le film mince supraconducteur,
- à fournir, après la formation du film métallique multicouche, du dioxyde d'azote gazeux comme oxydant pour oxyder ledit film métallique multicouche, et
- à répéter la même opération un nombre prédéterminé de fois afin de former un film mince d'oxyde supraconducteur haute température ayant une épaisseur prédéterminée.

2. Procédé conforme à la revendication 1, caractérisé en ce que, dans ladite étape d'oxydation consistant à fournir du dioxyde d'azote gazeux comme oxydant pour oxyder ledit film métallique multicouche, la température est maintenue entre 300 °C et 380 °C.

3. Procédé conforme à la revendication 1, caractérisé en ce que, dans ladite étape d'oxydation consistant à fournir du dioxyde d'azote comme oxydant pour oxyder ledit film métallique multicouche, le vide est maintenu à environ 1,33 × 10⁻⁵ Pa (10⁻⁷ Torr).
